(19) Europäisches Patentamt / European Patent Office / Office européen des brevets

(11) EP 3 761 347 B1

(12) **EUROPEAN PATENT SPECIFICATION**

(45) Date of publication and mention
of the grant of the patent:
**19.11.2025 Bulletin 2025/47**

(51) International Patent Classification (IPC):
**H01L 21/48** *(2006.01)* **H01L 23/498** *(2006.01)*

(21) Application number: **19425049.4**

(52) Cooperative Patent Classification (CPC):
**H01L 23/49827; H01L 21/486; H01L 23/49811**

(22) Date of filing: **04.07.2019**

(54) **OPEN WEB ELECTRICAL SUPPORT FOR CONTACT PAD AND METHOD OF MANUFACTURE**

ELEKTRISCHE OPEN-WEB-UNTERSTÜTZUNG FÜR KONTAKTPAD UND VERFAHREN ZUR HERSTELLUNG

SUPPORT ÉLECTRIQUE WEB OUVERT POUR PLOT DE CONTACT ET PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.01.2021 Bulletin 2021/01**

(73) Proprietor: **Hypertac S.p.a.**
**16153 Genova (IT)**

(72) Inventors:
• **BOSCA, Alessandro**
**16153 Genova (IT)**
• **BENTZ, Jedidiah**
**16153 Genova (IT)**
• **MUSARAMTHOTA, Vishai**
**16153 Genova (IT)**
• **KEMPSHALL, Scott R.**
**16153 Genova (IT)**
• **HENRY, Dave**
**16153 Genova (IT)**
• **DENZI, Agnese**
**16153 Genova (IT)**

(74) Representative: **Vienne, Aymeric Charles Emile**
**Mathys & Squire**
**The Shard**
**32 London Bridge Street**
**London SE1 9SG (GB)**

(56) References cited:
EP-A2- 2 061 077     WO-A1-2011/123717
US-A1- 2005 142 933     US-A1- 2005 208 785
US-A1- 2005 282 409     US-A1- 2006 234 056
US-A1- 2011 039 459     US-A1- 2014 302 579

**Description**

FIELD OF INVENTION

The invention relates, but is not limited to, an electrical support for at least one electrical contact pad. The invention also relates to a method of manufacture of such a support.

BACKGROUND

Known electrical supports enable electrical conduction to or from at least one electrical contact pad, such as a contact pad for a chip. Some supports may be used as interposers between printed circuit boards, PCB. US 2005/208785 A1 disloses fuzz button and spring contacts in a LGA interposer.

SUMMARY

Aspects and embodiments of the invention are set out in the appended claims. These and other aspects and embodiments of the invention are also described herein.

BRIEF PRESENTATION OF DRAWINGS

Aspects of the disclosure will now be described, by way of example, with reference to the accompanying drawings in which:

Figure 1A is an elevation view, in a longitudinal cross section, which schematically illustrates an electrical support for at least one electrical contact pad according to the disclosure, not subjected to a load;
Figure 1B is an elevation view, in a longitudinal cross section, which schematically illustrates the support of Figure 1A subjected to a load;
Figure 2A is an elevation view, in a longitudinal cross section, which schematically illustrates a first example electrical support according to the disclosure, not subjected to a load;
Figure 2B is an elevation view, in a longitudinal cross section, which schematically illustrates the support of Figure 2A subjected to a load;
Figure 3A is an elevation view, in a longitudinal cross section, which schematically illustrates a second example electrical support according to the disclosure, not subjected to a load;
Figure 3B is an elevation view, in a longitudinal cross section, which schematically illustrates the support of Figure 3A subjected to a load;
Figure 4 schematically illustrates example steps of a method of manufacture of a support of any one of the aspects of the disclosure.

In the drawings, similar elements bear identical numerical references.

SPECIFIC DESCRIPTION

Overview

The disclosure relates but is not limited to an electrical support for at least one electrical contact pad. The support comprises an insulating viscoelastic matrix in which is partly embedded at least one elastically deformable structure made of a conductive material. Each of the structures forms an open web, such as a foam, a network, a scaffolding or a lattice. Each structure comprises a stiffer section corresponding substantially to a part of the structure which is embedded in the matrix and a more flexible section corresponding substantially to a part of the structure which is connected to the electrical contact pad, outside the matrix.
The matrix provides substantially a thickness of the support, mechanical reinforcement to the structures and chemical stability to the structures.
Each structure is conductive and the open web provides multiple points of electrical contacts to the contact pad, as well as multiple conduction paths to and from the contact pad.
Each structure is elastically deformable and the more flexible section not embedded in the matrix provides compliance with deformations under which the support undergoes when subjected to a load. However the stiffer section reinforces the structure against over compression under the load and limits wear damage to the support.
The matrix may comprise a hydrophobic material and may provide a stop layer and may seal the support from moisture and other contaminants.

Detailed description of example embodiments

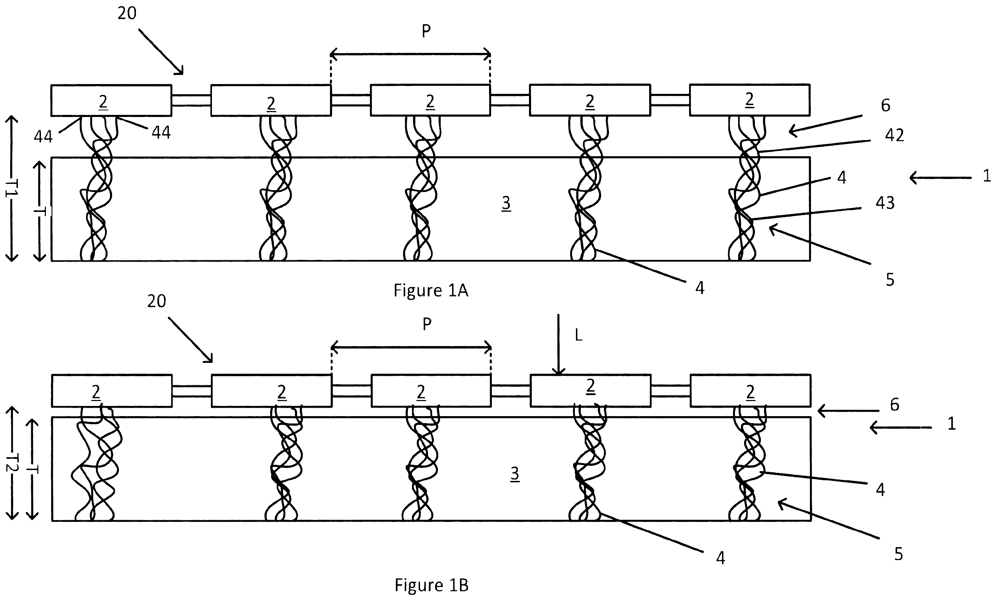

Figures 1A and 1B schematically illustrate an electrical support 1 for at least one electrical contact pad 2.
The support 1 comprises an insulating viscoelastic matrix 3.
The support 1 also comprises at least one elastically deformable structure 4 made of a conductive material.
As illustrated in Figures 1A and 1B, each structure 4 forms an open web. In the context of the present disclosure, an open web refers to interconnected elements leaving spaces between them, such as a foam, a network (such as a network of beams or strings), a scaffolding (such as a scaffolding of beams or strings) or a lattice (such as a lattice of beams or strings).
Each structure 4 is conductive and the open web provides multiple points 44 of electrical contacts to the contact pad 2, as well as multiple conduction paths to and from the contact pad 2.
Each structure 4 is at least partly embedded in the matrix 3. In Figure 1A the support 1 has a thickness T1 and in Figure 1B the support 1 has a thickness T2, however a thickness T of the matrix 3 may provide substantially a thickness of the support 1, i.e. the majority of the thicknesses T1 or T2 of the support 1 is formed from the thickness T of the matrix 3, and T is substantially constant even when the support 1 is subjected to a load L (as illustrated in Figure 1B). In some non-limiting examples,

$$T \geq 0.5 \times T1,$$

and/or

$$T \geq 0.5 \times T2.$$

The matrix 3 also provides mechanical reinforcement to the at least one structure 4 and chemical stability to the at least one structure 4. The matrix 3 enables maintaining the structural stability of the open web structure 4. The matrix 3 enables maintaining the spaces between the interconnected elements of the open web structure 4.

Each structure 4 comprises at least:

a core part 5 which is embedded within the insulating matrix 3, and
at least one connection part 6 which extends out of the insulating matrix 3 and is configured to be connected to the at least one electrical contact pad 2.

Each structure 4 comprises a stiffer section 43 corresponding substantially to the core part 5 of the structure 4. The stiffer section 43 reinforces the structure 4 against over compression under the load L applied to the support 1, as illustrated in Figure 1B. It should be understood that, in some examples, the stiffer section 43 may extend outside the matrix 3.

Alternatively or additionally, each structure 4 also comprises at least one more flexible section 42 corresponding substantially to the at least one connection part 6 of the structure 4. Each structure 4 is elastically deformable, and the more flexible section 42, substantially not embedded in the matrix 3, provides compliance with deformations the support 1 undergoes when subjected to the load L, as illustrated in Figure 1B with T2<T1. The matrix 3 enables maintaining and enhancing the elastic compliancy of the open web structure 4. It should be understood that, in some examples, the more flexible section 42 may be embedded in the matrix 3.

The at least one more flexible section 42 substantially provides the multiple points 44 of electrical contacts to the contact pad 2, as well as multiple conduction paths to and from the contact pad 2 (in combination with the stiffer section 43).

In some examples, the viscoelastic matrix 3 is made of a material comprising a hydrophobic elastomer. The matrix 3 may provide a stop layer and may seal the support 1 from moisture and other contaminants.

In some examples, the structure 4 comprises a structure made of a carbon-based material. In such examples, the material of the carbon-based structure may comprise a carbon allotrope. The carbon allotrope may comprise at least one of:

one or more carbon nanotubes, CNT;
one or more carbon nanobuds;
one or more carbon peapods;
one or more graphenated one or more CNTs;
one or more 3D nanoarchitectures comprising a mix of graphene and CNTs;
a glassy carbon;
a graphene;
one or more fullerenes;
one or more graphitic foliates; and/or
a carbon nanofoam.

The CNT may be single-walled or may comprise a plurality of walls and diameters. Non-limiting examples include at least one of double-walled carbon nanotubes (DWNTs) and/or multi-walled carbon nanotubes (MWCNTs).

As stated above, the CNTs may be hybridized with other carbon allotropes, and non-limiting examples of other carbon allotropes include fullerenes, graphitic foliates, graphene, the carbon allotropes thus forming other morphologies such as carbon nanobuds, carbon peapods, graphenated CNTs, graphene and CNTs 3D nanoarchitectures. Non-limiting examples of 3D nanoarchitectures include scaffoldings, foams and networks, such as pillared graphene. CNTs may be connected by themselves and/or integrated with other carbon allotropes by junctions or cross-linking. All of the above combinations may be incorporated in glassy carbon.

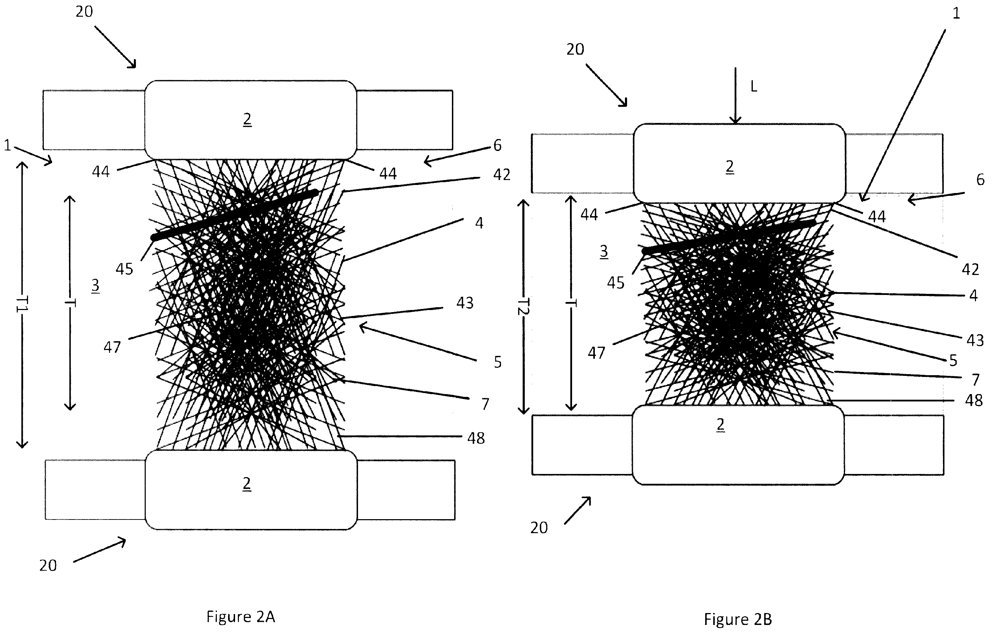

In some examples, the carbon-based structure may comprise a highly-ordered network of CNT. Alternatively or additionally, as illustrated in Figures 2A and 2B, the carbon-based structure 4 may comprise a random network 7 of CNT. In some examples, the random network of CNT may include CNT sponges.

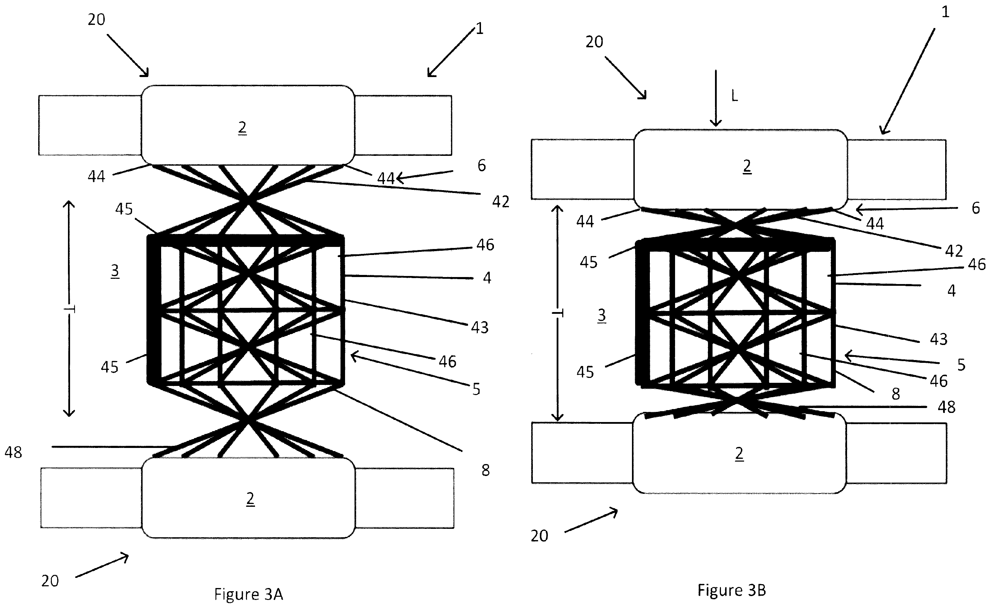

Alternatively or additionally, as illustrated in Figures 3A and 3B, the carbon-based structure may comprise a glassy carbon nanolattice 8 and/or a CNT nanolattice 8.

In some examples, the glassy carbon nanolattice 8 further comprises a thin layer of metal to enhance the electrical conductivity of the nanolattice. The thin layer of metal may comprise a thin layer of at least one of lead, platinum, gold or titanium, but other metals are envisaged.

Alternatively or additionally, one or more types of CNTs may be chosen among different types of CNTs in order to obtain suitable mechanical and electrical properties of the one or more structures 4. The different types of CNTs include at least one of CNTs with different numbers of walls, different chiralities, different beam or string diameters and/or different surface chemistries. It should be understood that chirality may have an impact directly on electrical properties of the CNTs, but may also have an impact indirectly on a size and a stability of the CNTs. It should be understood that surface properties may have an impact on how the CNTs conduct electricity and on how the CNTs react between themselves, with other carbon allotropes and/or with the matrix. The surface properties may also contribute to the architecture topology and stability of the structure, and may contribute to integration of the structure within the surrounding matrix.

Alternatively or additionally, the structure may comprise a structure made of nanowires and/or nanofibers, as non-limiting examples. The nanowires and/or nanofibers may be composed of at least one of:

> one or more metals (non-limiting examples include silver, tungsten, nickel, copper, gold, zinc, platinum, tin and relative alloys);
> semiconductors (non-limiting examples include silicon, indium phosphide, gallium nitride or carbon); and/or
> superconductors (such as yttrium barium copper oxide YBCO).

Alternatively or additionally, the structure may comprise a structure made of nanowires and/or nanofibers composed of insulators (non-limiting examples include SiO2 and TiO2). Non-conductive nanowires and/or nanofibers may be used to improve the mechanical properties of the structures.

In some examples, the stiffer section 43 may comprise thicker beams or strings 45 than beams or strings in the more flexible section 42 (e.g. Figures 2A and 2B and Figures 3A and 3B). Alternatively or additionally, the stiffer section 43 may comprise more beams or strings 46 which are substantially perpendicular to the at least one electrical contact pad 2 than the more flexible section 42 (e.g. Figures 3A and 3B). In some examples, the stiffer section 43 may comprise a higher density 47 of the web than the more flexible section 42 (e.g. Figures 2A and 2B). Alternatively or additionally, the stiffer section 43 may comprise more interconnections of the web than the more flexible section 42 (e.g. Figures 2A and 2B). Differences may include differences in the topology and interconnections between the carbon allotropes obtained through different cross-linkers and junctions, in order to form 3D architectures with different densities and suitable mechanical properties.

Alternatively or additionally, the stiffer section 43 may comprise one or more different types of CNTs compared to CNTs in the more flexible section 42. Differences may include at least one of different number of walls, chirality, diameter and/or surface chemistry as explained above.

Alternatively or additionally, the stiffer section 43 may comprise a different combination of carbon allotropes (CNTs, graphene and hybrids as already stated) compared to the more flexible section 42. Differences may also include differences in the topology and interconnections between the carbon allotropes obtained through different cross-linkers and junctions in order to form 3D architectures with different densities and suitable mechanical properties. Differences may also comprise differences in the surface properties of the carbon allotropes compared to the surface properties of the ones in the more flexible section 42. The surface properties may contribute to the architecture topology and stability of the structure as well as the proper integration of the structure with the surrounding matrix and the electrical conductivity of the structure.

Alternatively or additionally, the stiffer section may comprise a higher density of CNT than the more flexible section. Alternatively or additionally, the stiffer section may comprise a higher density of a nanolattice than the more flexible section.

As illustrated in Figures 2A, 2B, 3A and 3B, the support 1 may be configured to support two arrays 20 of e.g. only one pad 2. As illustrated in Figures 1A and 1B, the support 1 may be configured to support only one array 20.

As illustrated in Figures 2A, 2B, 3A and 3B, the support 1 may be configured to be an interposer between two arrays 20 of at least one electrical contact pad 2. The arrays 20 illustrated in Figures 2A, 2B, 3A and 3B comprise only one pad 2, but it should be understood that each array 20 could comprise a plurality of pads 2.

As illustrated in Figures 2A, 2B, 3A and 3B, the connection part 42 of the structure 4 may be connected to a first array 20 of the two arrays 20. The structure 4 further comprises a second connection part 48 which extends out of the insulating matrix 3 and is configured to be connected to a second array 20 of the two arrays 20.

As illustrated in Figures 1A and 1B, the plurality of electrical contact pads 2 may be separated by a pitch P. In some examples, P may be such that:

$$0 < P \le 0.3 \text{ mm}$$

(i.e. 300 μm).

As explained in greater detail below, methods of manufacturing of the support, according to the disclosure, enable scalability of the support, such that, in some examples, the pitch P may be such that:

$$0 < P \le 0.01 \text{ mm (10 μm),}$$

or

$$0 < P < 0.001 \text{ mm}$$

(i.e. submicron pitch).

Other dimensions may be envisaged, and the pitch P may be larger than 0.3 mm (300 μm).

Alternatively or additionally, the thickness T of the insulating viscoelastic matrix 3 may be such that:

$$0 < T \leq 0.3 \text{ mm}$$

(i.e. 300 μm).

As already stated, the methods of manufacturing of the support, according to the disclosure, enable scalability of the support, such that, in some examples, the thickness T may be such that:

$$0 < T \leq 0.01 \text{ mm (10 μm),}$$

or

$$0 < T < 0.001 \text{ mm}$$

(i.e. submicron thickness).

Other dimensions may be envisaged, and the thickness T may be larger than 0.3 mm (300 μm).

The disclosure also relates to electrical devices comprising the electrical support 1 of any aspects of the disclosure and at least one electrical contact pad connected to the connection part 42 (or 48 when present) of the structure 4 of the support 1.

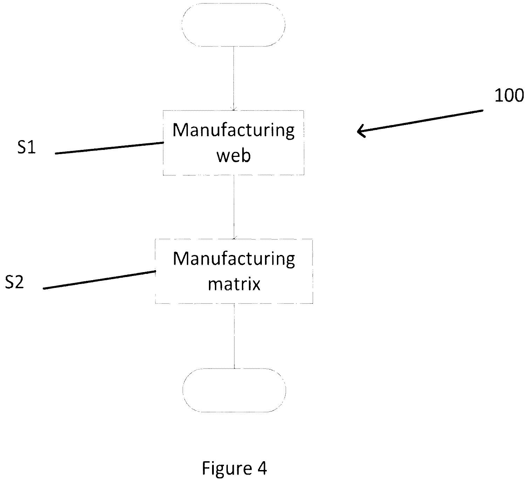

Figure 4 schematically illustrates a method 100 of manufacturing an electrical support for at least one electrical contact pad.

The method 100 comprises:

manufacturing, at S1, at least one elastically deformable, open web structure made of a conductive material; and
manufacturing, at S2, an insulating viscoelastic matrix.

At S2, the manufacturing is performed such that the structure comprises at least a core part which is embedded within the insulating matrix, and at least one connection part which extends out of the insulating matrix and is configured to be connected to the electrical contact pad. At S2, the manufacturing is performed such that the structure comprises a stiffer section corresponding substantially to the core part of the structure and at least one more flexible section corresponding substantially to the at least one connection part of the structure.

The method 100 may be performed to manufacture the support 1 of any aspects of the disclosure.

As already stated, the one or more structures may comprise one or more CNTs which may be single-walled or may comprise a plurality of walls and diameters. The CNTs may be hybridized with other carbon allotropes, and non-limiting examples of other carbon allotropes include fullerenes, graphitic foliates, graphene, the carbon allotropes thus forming other morphologies such as carbon nanobuds, carbon peapods, graphenated CNTs, a graphene and/or CNTs 3D nanoarchitectures. Non-limiting examples of 3D nanoarchitectures include scaffoldings, foams and networks, such as pillared graphene. CNTs may be connected by themselves and/or integrated with other carbon allotropes by junctions or cross-linking. All of the above combinations may be incorporated in glassy carbon. The one or more structure may also comprise a structure made of nanowires and/or nanofibers.

In some non-limiting examples, manufacturing the one or more structures at S1 may comprise enabling the one or more structures to self-assemble in a highly-ordered network or a random network. Alternatively or additionally, manufacturing the one or more structures at S1 may comprise engineering one or more initial structures by 3D lithography and obtaining one or more final structures using pyrolysis. Alternatively or additionally, manufacturing the one or more structures at S1 and the matrix at S2 may comprise engineering one or more initial structures by 3D lithography by embedding the one or more structures inside an insulating viscoelastic matrix and obtaining one or more structures using pyrolysis.

The method 100 enables scalability of the support to predetermined and desired dimensions. Alternatively or additionally, the method 100 enables engineering of the mechanical, chemical and/or conductive properties of the support to predetermined and desired properties.

In some examples, the manufacturing at S1 of the structure further comprises depositing a thin layer of metal on the glassy carbon nanolattice to enhance the electrical conductivity of the nanolattice. The thin layer of metal may comprise a thin layer of at least one of lead, platinum, gold or titanium, but other metals are envisaged. In some non-limiting examples, depositing the thin layer of metal may be performed by Atomic Layer Deposition, ALD, but other methods may be envisaged.

The support of any aspects of the disclosure may be configured to be used in at least one of:

a Land Grid Array, LGA,
a board-to-board connector, such as an interposer,
a board-to-flex connector, such as an interposer,
an application-specific integrated circuit, ASIC,
a device with a pin count of up to several thousand I/O, and/or
an anisotropic conductive film for flip-chip integrated circuit, IC, assembly.

The above examples are non-limiting and other applications may be envisaged.

**Claims**

1. An electrical support (1) for at least one electrical contact pad (2), comprising:

an insulating viscoelastic matrix (3); and
at least one elastically deformable structure (4)

made of a conductive material to form an open web, the at least one structure (4) comprising at least:

a core part (5) which is embedded within the insulating matrix, and
at least one connection part (6) which extends out of the insulating matrix and is configured to be connected to the at least one electrical contact pad,

**characterized in that** the structure (4) comprises a stiffer section (43) corresponding substantially to the core part (5) of the structure (4) and at least one more flexible section (42) corresponding substantially to the at least one connection part (6) of the structure (4).

2. The support (1) of claim 1, wherein the viscoelastic matrix (3) is made of a material comprising a hydrophobic elastomer.

3. The support (1) of any one of the preceding claims, wherein the structure (4) comprises a structure made of a carbon-based material, optionally wherein the material of the carbon-based structure comprises at least one carbon allotrope.

4. The support (1) of claim 3, wherein the at least one carbon allotrope comprises at least one of:

one or more carbon nanotubes, CNTs;
one or more carbon nanobuds;
one or more carbon peapods;
one or more graphenated one or more CNTs;
one or more 3D nanoarchitectures comprising a mix of graphene and at least one CNT;
a glassy carbon;
a graphene;
one or more fullerenes;
one or more graphitic foliates; and/or
a carbon nanofoam,

optionally wherein the carbon-based structure (4) comprises a highly-ordered or random network of CNTs, including CNT sponges, or optionally wherein the carbon-based structure comprises a glassy carbon nanolattice and/or a CNT nanolattice, optionally wherein the glassy carbon nanolattice further comprises a thin layer of metal to enhance the electrical conductivity of the nanolattice, optionally wherein the thin layer of metal comprises a thin layer of at least one of lead, platinum, gold or titanium.

5. The support (1) of any one of the preceding claims, wherein the structure (4) comprises a structure made of nanowires and/or nanofibers, such as nanowires and/or nanofibers composed of at least one of:

one or more metals;
semiconductors; and/or
superconductors.

6. The support (1) of any one of the preceding claims, wherein the stiffer section (43) comprises at least one of:

thicker beams or strings than beams or strings in the more flexible section; and/or
more beams or strings which are substantially perpendicular to the at least one electrical contact pad than the more flexible section;
more interconnections of the web than the more flexible section; and/or
a higher density of the web than the more flexible section.

7. The support (1) of any one of claims 4 to 6, wherein the stiffer section (43) comprises at least one of:

one or different types of CNTs compared to CNTs in the more flexible section, comprising at least one of:

a different chirality of CNTs compared to a chirality of CNTs in the more flexible section; and/or
a different number of walls for the CNTs compared to a number of walls for the CNTs in the more flexible section;
a different diameter of CNTs compared to a diameter of CNTs in the more flexible section; and/or
different surface properties of CNTs compared to surface properties of CNTs in the more flexible section;

a different combination of carbon allotropes compared to the more flexible section, including differences in the topology and interconnections between the carbon allotropes and/or differences in surface properties of carbon allotropes; and/or
a higher density of CNT than the more flexible section; and/or
a higher density of a nanolattice than the more flexible section.

8. The support (1) of any one of the preceding claims, configured to be an interposer between two arrays (20) of at least one electrical contact pad, a first connection part (6) of the structure (4) being configured to be connected to a first array of the two arrays of the at least one electrical contact pad, and wherein the structure further comprises a second connection part (6) which extends out of the insulating matrix (3) and is configured to be connected to a second array of the two arrays of the at least one electrical contact pad.

9. The support (1) of any one of the preceding claims, configured for at least one array (20) comprising a plurality of electrical contact pads separated by a pitch **P,** wherein P is such that:

$$0 < P \le 0.3 \text{ mm,}$$

optionally wherein the pitch P is such that:

$$0 < P \le 0.01 \text{ mm,}$$

optionally wherein P is such that:

$$0 < P < 0.001 \text{ mm, or}$$

wherein the insulating viscoelastic matrix has a thickness T, wherein T is such that:

$$0 < T \le 0.3 \text{ mm,}$$

optionally wherein the thickness T is such that:

$$0 < T \le 0.01 \text{ mm,}$$

optionally wherein the thickness T is such that:

$$0 < T < 0.001 \text{ mm.}$$

10. The support (1) of any one of the preceding claims, configured to be used in at least one of:

a Land Grid Array, LGA,
a board-to-board connector, such as an interposer,
a board-to-flex connector, such as an interposer,
an application-specific integrated circuit, ASIC,
a device with a pin count of up to several thousand I/O,
an anisotropic conductive film for flip-chip integrated circuit, IC, assembly.

11. An electrical device, comprising:

the electrical support (1) of any one of the preceding claims; and
at least one electrical contact pad (2) connected to the connection part of the structure of the support.

12. A method of manufacturing an electrical support (1) for at least one electrical contact pad (2), comprising:

manufacturing at least one elastically deformable, open web structure (4) made of a conductive material; and
manufacturing an insulating viscoelastic matrix (3), such that the at least one structure comprises at least:

a core part (5) which is embedded within the insulating matrix (3), and
at least one connection part (6) which extends out of the insulating matrix (3) and is configured to be connected to the electrical contact pad (2),

**characterized in that** the structure (4) comprises a stiffer section (43) corresponding substantially to the core part (5) of the structure (4) and at least one more flexible section (42) corresponding substantially to the at least one connection part (6) of the structure (4).

13. The method of claim 12, for manufacturing the support (1) of any one of claims 1 to 10.

14. The method of claim 12 or 13, wherein manufacturing the at least one structure (4) comprises using a least one of:

enabling one or more structures to self-assemble in a highly-ordered or random network; and/or
engineering one or more initial structures by 3D lithography and obtaining one or more final structures using pyrolysis; and/or
engineering one or more initial structures by 3D lithography by embedding the one or more initial structures inside an insulating viscoelastic matrix and obtaining one or more final structures using pyrolysis.

15. The method of claim 14, wherein the manufacturing of the at least one structure (4) further comprises depositing a thin layer of metal to enhance the electrical conductivity, optionally further comprising depositing the thin layer of metal by Atomic Layer Deposition, ALD.

**Patentansprüche**

1. Elektrischer Träger (1) für mindestens eine elektrische Kontaktfläche (2), der Folgendes umfasst:

eine isolierende viskoelastische Matrix (3); und
mindestens eine elastisch verformbare Struktur (4), die aus einem leitfähigen Material hergestellt ist, um einen offenen Steg zu bilden, wobei die mindestens eine Struktur (4) mindestens Folgendes umfasst:

ein Kernteil (5), das in die isolierende Matrix eingebettet ist, und
mindestens ein Verbindungteil (6), das sich aus der isolierenden Matrix heraus erstreckt und so gestaltet ist, dass es mit der mindestens einen elektrischen Kontaktfläche verbunden werden kann,

**dadurch gekennzeichnet, dass** die Struktur (4) einen steiferen Abschnitt (43), der im Wesentlichen dem Kernteil (5) der Struktur (4) entspricht, und mindestens einen flexibleren Abschnitt (42) umfasst, der im Wesentlichen dem mindestens einen Verbindungteil (6) der Struktur (4) entspricht.

2. Träger (1) nach Anspruch 1, wobei die viskoelastische Matrix (3) aus einem Material hergestellt ist, das ein hydrophobes Elastomer umfasst.

3. Träger (1) nach einem der vorhergehenden Ansprüche, wobei die Struktur (4) eine Struktur aus einem Material auf Kohlenstoffbasis umfasst, wobei optional das Material der kohlenstoffbasierten Struktur mindestens ein Kohlenstoff-Allotrop umfasst.

4. Träger (1) nach Anspruch 3, wobei das mindestens eine Kohlenstoff-Allotrop mindestens eines der Folgenden umfasst:

ein oder mehrere Kohlenstoff-Nanoröhrchen (Carbon Nanotubes, CNTs);
eine oder mehrere Kohlenstoff-Nanobuds;
eine oder mehrere Kohlenstoff-Peapods;
eine oder mehrere graphenierte ein oder mehrere CNTs;
eine oder mehrere 3D-Nanoarchitekturen, die eine Mischung aus Graphen und mindestens einem CNT umfassen;
einen glasartigen Kohlenstoff;
ein Graphen;
ein oder mehrere Fullerene;
ein oder mehrere graphitische Foliate; und/oder
einen Kohlenstoff-Nanoschaum,
wobei optional die kohlenstoffbasierte Struktur (4) ein hochgeordnetes oder zufälliges Netzwerk von CNTs, einschließlich CNT-Schwämmen, umfasst, oder wobei optional die kohlenstoffbasierte Struktur ein glasartiges Kohlenstoff-Nanolattice und/oder ein CNT-Nanolattice umfasst, wobei optional das glasartige Kohlenstoff-Nanolattice ferner eine dünne Metallschicht umfasst, um die elektrische Leitfähigkeit des Nanolattices zu verbessern, wobei optional die dünne Schicht aus Metall eine dünne Schicht aus mindestens einem der Elemente Blei, Platin, Gold oder Titan umfasst.

5. Träger (1) nach einem der vorhergehenden Ansprüche, wobei die Struktur (4) eine Struktur aus Nanodrähten und/oder Nanofasern umfasst, wie Nanodrähte und/oder Nanofasern, die aus mindestens einem der Folgenden bestehen:

einem oder mehreren Metallen;
Halbleitern; und/oder
Supraleitern.

6. Träger (1) nach einem der vorhergehenden Ansprüche, wobei der steifere Abschnitt (43) mindestens eines der folgenden Merkmale aufweist:

dickere Balken oder Stränge als Balken oder Stränge in dem flexibleren Abschnitt; und/oder
mehr Balken oder Stränge, die im Wesentlichen senkrecht zu der mindestens einen elektrischen Kontaktfläche verlaufen als der flexiblere Abschnitt;
mehr Verbindungen des Stegs als im flexibleren Abschnitt; und/oder
eine höhere Dichte des Stegs als der flexiblere Abschnitt.

7. Träger (1) nach einem der Ansprüche 4 bis 6, wobei der steifere Abschnitt (43) mindestens eines der folgenden Merkmale aufweist:

eine oder verschiedene Arten von CNTs im Vergleich zu den CNTs im flexibleren Abschnitt, die mindestens eines der Folgenden umfassen:

eine andere Chiralität der CNTs im Vergleich zu einer Chiralität der CNTs in dem flexibleren Abschnitt; und/oder
eine andere Anzahl von Wänden für die CNTs im Vergleich zu einer Anzahl von Wänden für die CNTs in dem flexibleren Abschnitt;
einen anderen Durchmesser der CNTs im Vergleich zu einem Durchmesser der CNTs in dem flexibleren Abschnitt; und/oder
unterschiedliche Oberflächeneigenschaften der CNTs im Vergleich zu den Oberflächeneigenschaften der CNTs in dem flexibleren Abschnitt;

eine andere Kombination von Kohlenstoff-Allotropen im Vergleich zu dem flexibleren Abschnitt, einschließlich Unterschieden in der Topologie und den Verbindungen zwischen den Kohlenstoff-Allotropen und/oder Unterschieden in den Oberflächeneigenschaften der Kohlenstoff-Allotropen; und/oder
eine höhere Dichte an CNT als der flexiblere Abschnitt; und/oder
eine höhere Dichte eines Nanogitters als der flexiblere Abschnitt.

8. Träger (1) nach einem der vorhergehenden Ansprüche, der so konfiguriert ist, dass er ein Zwischenstück zwischen zwei Arrays (20) aus mindestens einer elektrischen Kontaktfläche ist, wobei ein erstes Verbindungsteil (6) der Struktur (4) so konfiguriert ist, dass es mit einer ersten Anordnung der beiden Anordnungen der mindestens einen elektrischen Kontaktfläche verbunden werden kann, und wobei die Struktur ferner ein zweites Verbindungsteil (6) umfasst, das sich aus der isolierenden Matrix (3) heraus erstreckt und so konfiguriert ist, dass es mit einer zweiten Anordnung der zwei Anordnungen der mindestens einen elektrischen Kontaktfläche verbunden werden kann.

9. Träger (1) nach einem der vorhergehenden Ansprüche, der für mindestens ein Array (20) konfiguriert ist, das eine Vielzahl von elektrischen Kontaktflächen umfasst, die durch einen Abstand P getrennt sind, wobei P derart ist, dass:

$$0 < P \leq 0,3 \ \text{mm},$$

wobei optional der Abstand P derart ist, dass:

$$0 < P \leq 0,01 \ \text{mm},$$

wobei optional P derart ist, dass:

$$0 < P < 0,001 \ \text{mm oder}$$

wobei die isolierende viskoelastische Matrix eine Dicke T aufweist, wobei T derart ist, dass:

$$0 < T \leq 0,3 \ \text{mm},$$

wobei optional die Dicke T derart ist, dass:

$$0 < T \leq 0,01 \ \text{mm},$$

wobei optional die Dicke T derart ist, dass:

$$0 < T < 0,001 \ \text{mm}.$$

10. Träger (1) nach einem der vorhergehenden Ansprüche, der so konfiguriert ist, dass er in mindestens einem der Folgenden verwendet werden kann:

einem Land Grid Array, LGA,
einem Board-to-Board-Verbinder, wie z.B. einem Interposer,
einem Board-to-Flex-Verbinder, wie z. B. einem Interposer,
einer anwendungsspezifischen integrierten Schaltung, ASIC,
einer Vorrichtung mit einer Pinanzahl von bis zu mehreren tausend E/A,
einer anisotropen leitfähige Folie für die Flip-Chip-Montage integrierter Schaltungen (IC).

11. Elektrische Vorrichtung, die Folgendes umfasst:

den elektrischen Träger (1) nach einem der vorhergehenden Ansprüche; und
mindestens eine elektrische Kontaktfläche (2), die mit dem Verbindungsteil der Struktur des Trägers verbunden ist.

12. Verfahren zur Herstellung eines elektrischen Trägers (1) für mindestens ein elektrisches Kontaktfläche (2), das umfasst:

Herstellen mindestens einer elastisch verformbaren, offenen Stegstruktur (4) aus einem leitfähigen Material; und
Herstellen einer isolierenden viskoelastischen Matrix (3), so dass die mindestens eine Struktur mindestens umfasst:

ein Kernteil (5), das in die isolierende Matrix (3) eingebettet ist, und
mindestens ein Verbindungsteil (6), das sich aus der isolierenden Matrix (3) heraus erstreckt und so konfiguriert ist, dass es mit dem elektrischen Kontaktfläche (2) verbunden werden kann,

**dadurch gekennzeichnet, dass** die Struktur (4) einen steiferen Abschnitt (43), der im Wesentlichen dem Kernteil (5) der Struktur (4) entspricht, und mindestens einen flexibleren Abschnitt (42) umfasst, der im Wesentlichen dem mindestens einen Verbindungsteil (6) der Struktur (4) entspricht.

13. Verfahren nach Anspruch 12 zur Herstellung des Trägers (1) nach einem der Ansprüche 1 bis 10.

14. Verfahren nach Anspruch 12 oder 13, wobei die Herstellung der mindestens einen Struktur (4) die Verwendung mindestens eines der Folgenden umfasst:

Ermöglichen einer oder mehrerer Strukturen, sich selbst in einem hochgeordneten oder zufälligen Netzwerk zu assemblieren; und/oder
Herstellen einer oder mehrerer Ausgangsstrukturen durch 3D-Lithographie und Gewinnung einer oder mehrerer Endstrukturen durch Pyrolyse; und/oder
Herstellen einer oder mehrerer Ausgangsstrukturen durch 3D-Lithographie durch Einbetten der einen oder mehreren Ausgangsstrukturen in eine isolierende viskoelastische Matrix und Gewinnen einer oder mehrerer Endstrukturen durch Pyrolyse.

15. Verfahren nach Anspruch 14, wobei das Herstellen der mindestens einen Struktur (4) ferner das Abscheiden einer dünnen Metallschicht zur Verbesserung der elektrischen Leitfähigkeit umfasst, wobei die dünne Metallschicht optional ferner durch Atomic Layer Deposition (ALO) abgeschieden wird.

**Revendications**

1. Support électrique (1) pour au moins une plage de contact électrique (2), comprenant :

   une matrice viscoélastique isolante (3) ; et
   au moins une structure élastiquement déformable (4) faite d'un matériau conducteur pour former une bande ouverte, l'au moins une structure (4) comprenant au moins :

   une partie centrale (5) qui est intégrée dans la matrice isolante, et
   au moins une partie de connexion (6) qui s'étend hors de la matrice isolante et est configurée pour être connectée à l'au moins une plage de contact électrique,

   **caractérisé en ce que** la structure (4) comprend une section plus rigide (43) correspondant sensiblement à la partie centrale (5) de la structure (4) et au moins une section plus flexible (42) correspondant sensiblement à l'au moins une partie de connexion (6) de la structure (4).

2. Support (1) selon la revendication 1, dans lequel la matrice viscoélastique (3) est faite d'un matériau comprenant un élastomère hydrophobe.

3. Support (1) selon l'une quelconque des revendications précédentes, dans lequel la structure (4) comprend une structure faite d'un matériau à base de carbone, facultativement dans lequel le matériau de la structure à base de carbone comprend au moins un allotrope de carbone.

4. Support (1) selon la revendication 3, dans lequel l'au moins un allotrope de carbone comprend au moins un élément parmi :

   un ou plusieurs nanotubes de carbone, NTC ;
   un ou plusieurs nanobourgeons de carbone ;
   un ou plusieurs pois de carbone ;
   un ou plusieurs graphénés un ou plusieurs NTC ;

   une ou plusieurs nano-architectures 3D comprenant un mélange de graphène et d'au moins un NTC ;
   un carbone vitreux ;
   un graphène ;
   un ou plusieurs fullerènes ;
   un ou plusieurs feuillets graphitiques ; et/ou
   une nanomousse de carbone,
   facultativement dans lequel la structure à base de carbone (4) comprend un réseau hautement ordonné ou aléatoire de NTC, incluant des éponges de NTC, ou facultativement dans lequel la structure à base de carbone comprend un nanotreillis de carbone vitreux et/ou un nanotreillis de NTC, facultativement dans lequel le nanotreillis de carbone vitreux comprend en outre une fine couche de métal pour améliorer la conductivité électrique du nanotreillis, facultativement dans lequel la fine couche de métal comprend une fine couche d'au moins un élément parmi le plomb, le platine, l'or ou le titane.

5. Support (1) selon l'une quelconque des revendications précédentes, dans lequel la structure (4) comprend une structure faite de nanofils et/ou de nanofibres, tels que des nanofils et/ou des nanofibres composés d'au moins un élément parmi :

   un ou plusieurs métaux ;
   des semi-conducteurs ; et/ou
   des supraconducteurs.

6. Support (1) selon l'une quelconque des revendications précédentes, dans lequel la section plus rigide (43) comprend au moins un élément parmi :

   des faisceaux ou des chaînes plus épaisses que les faisceaux ou les chaînes dans la section plus flexible ; et/ou
   plus de faisceaux ou de chaînes qui sont sensiblement perpendiculaires à l'au moins une plage de contact électrique que la section plus flexible ;
   plus d'interconnexions de la bande que la section plus flexible ; et/ou
   une densité de la bande supérieure à celle de la section plus flexible.

7. Support (1) selon l'une quelconque des revendications 4 à 6, dans lequel la section plus rigide (43) comprend au moins un élément parmi :

   un ou plusieurs types de NTC par rapport aux NTC dans la section plus flexible, comprenant au moins un élément parmi :

   une chiralité différente des NTC par rapport à une chiralité des NTC dans la section plus flexible ; et/ou

un nombre de parois différent pour les NTC par rapport à un nombre de parois pour les NTC dans la section plus flexible ;

un diamètre différent des NTC par rapport à un diamètre des NTC dans la section la plus flexible ; et/ou

des propriétés de surface différentes des NTC par rapport aux propriétés de surface des NTC dans la section la plus flexible ;

une combinaison différente d'allotropes de carbone par rapport à la section plus flexible, incluant des différences dans la topologie et les interconnexions entre les allotropes de carbone et/ou des différences dans les propriétés de surface des allotropes de carbone ; et/ou une densité de NTC supérieure à celle de la section plus flexible; et/ou une densité d'un nanotreillis supérieure celle de la section plus souple.

8. Support (1) selon l'une quelconque des revendications précédentes, configuré pour être un interposeur entre deux réseaux (20) d'au moins une plage de contact électrique, une première partie de connexion (6) de la structure (4) étant configurée pour être connectée à un premier réseau des deux réseaux de l'au moins une plage de contact électrique, et dans lequel la structure comprend en outre une deuxième partie de connexion (6) qui s'étend hors de la matrice isolante (3) et est configurée pour être connectée à un deuxième réseau des deux réseaux de l'au moins une plage de contact électrique.

9. Support (1) selon l'une quelconque des revendications précédentes, configuré pour au moins un réseau (20) comprenant une pluralité de plages de contact électrique séparées par un pas P, dans lequel P est tel que :

$$0 < P \leq 0,3 \text{ mm,}$$

facultativement dans lequel le pas P est tel que :

$$0 < P \leq 0,01 \text{ mm,}$$

facultativement dans lequel P est tel que :

$$0 < P < 0,001 \text{ mm,}$$

ou

dans lequel la matrice viscoélastique isolante a une épaisseur T, dans lequel T est telle que :

$$0 < T \leq 0,3 \text{ mm,}$$

facultativement dans lequel l'épaisseur T est telle que :

$$0 < T \leq 0,01 \text{ mm,}$$

facultativement dans lequel l'épaisseur T est telle que :

$$0 < T < 0,001 \text{ mm.}$$

10. Support (1) selon l'une quelconque des revendications précédentes, configuré pour être utilisé dans au moins un élément parmi :

un réseau de grille terrestre, LGA,
un connecteur carte à carte, tel qu'un interposeur,
un connecteur carte à ruban, tel qu'un interposeur,
un circuit intégré spécifique à l'application, ASIC,
un dispositif avec un nombre de broches allant jusqu'à plusieurs milliers d'E/S,
un film conducteur anisotrope pour un ensemble de circuit intégré , CI, à puce retournée.

11. Dispositif électrique, comprenant :

le support électrique (1) selon l'une quelconque des revendications précédentes ; et
au moins une plage de contact électrique (2) connectée à la partie de connexion de la structure du support.

12. Procédé de fabrication d'un support électrique (1) pour au moins une plage de contact électrique (2), comprenant :

la fabrication d'au moins une structure de bande ouverte élastiquement déformable (4) faite d'un matériau conducteur ; et
la fabrication d'une matrice viscoélastique isolante (3), de sorte que l'au moins une structure comprend au moins :

une partie centrale (5) qui est intégrée au sein de la matrice isolante (3), et
au moins une partie de connexion (6) qui s'étend hors de la matrice isolante (3) et est configurée pour être connectée à la plage de contact électrique,

**caractérisé en ce que** la structure (4) comprend une section plus rigide (43) correspondant sensiblement à la partie centrale (5) de la structure (4) et au moins une section plus flexible (42) correspondant sensiblement à l'au moins une partie de connexion (6) de la structure (4).

13. Procédé selon la revendication 12, destiné à fabriquer le support (1) selon l'une quelconque des revendications 1 à 10.

14. Procédé selon la revendication 12 ou 13, dans lequel la fabrication de l'au moins une structure (4) comprend l'utilisation d'au moins un élément parmi :

le fait de permettre à une ou plusieurs structures de s'auto-assembler dans un réseau hautement ordonné ou aléatoire ; et/ou
l'ingénierie d'une ou de plusieurs structures initiales par lithographie 3D et l'obtention d'une ou de plusieurs structures finales en utilisant la pyrolyse ; et/ou
la conception d'une ou de plusieurs structures initiales par lithographie 3D par l'intégration des une ou plusieurs structures initiales à l'intérieur d'une matrice viscoélastique isolante et par l'obtention d'une ou de plusieurs structures finales en utilisant la pyrolyse.

15. Procédé selon la revendication 14, dans lequel la fabrication de l'au moins une structure (4) comprend en outre le dépôt d'une couche mince de métal pour améliorer la conductivité électrique, comprenant facultativement en outre le dépôt de la couche mince de métal par dépôt de couches atomiques, ALD.

Figure 1A

Figure 1B

Figure 2B

Figure 2A

Figure 3A

Figure 3B

EP 3 761 347 B1

Figure 4

EP 3 761 347 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2005208785 A1